# EUROPÄISCHE PATENTANMELDUNG

(11) **EP 2 533 301 A2**
(43) Veröffentlichungstag der Anmeldung: **12.12.2012**
(21) Anmeldenummer: 12163545.2
(22) Anmeldetag: 10.04.2012
(51) Int. Cl.: H01L 31/048

(54) **Solarzellen-Dachsystem mit einer Mehrzahl von Solarmodulen**

(30) Priorität: 08.06.2011 DE 102011077229
(71) Anmelder: ROBERT BOSCH GMBH, 70442 Stuttgart (DE)
(72) Erfinder: Buettner, Thomas, 07745 Jena (DE); Funk, Karsten, 99425 Weimar (DE); Risto, Uwe, 99086 Erfurt (DE)

(57) **Zusammenfassung**

Solarzellen-Dachsystem mit einer Mehrzahl von Solarmodulen, von denen zumindest einige zur Realisierung eines Regenschutzes zusammenhängend übereinander zu montieren sind, wobei in oder an mindestens jeweils einer Kante der übereinander zu montierenden Solarmodule, die in Gebrauchslage eine Unterkante ist, Luftführungsmittel zur Zuführung von Umgebungsluft hinter die Rückseite des Solarmoduls vorgesehen sind.

## Beschreibung

Die Erfindung betrifft ein Solarzellen-Dachsystem mit einer Mehrzahl von Solarmodulen, von denen zumindest einige zur Realisierung eines Regenschutzes zusammenhängend übereinander zu montieren sind.

### Stand der Technik

Photovoltaikmodule (PV-Module) beinhalten Solarzellen bzw. photoelektrisch aktive Schichten, welche Licht in elektrischen Strom wandeln. Diese Module können mit Hilfe von Gestellen auf dem Boden ausgerichtet oder auf Dächer von Gebäuden und in Gebäudehüllen integriert werden. Bei der Integration in die Gebäudehülle können die Solarmodule Aufgaben dieser übernehmen, beispielsweise können sie den Wetterschutz, insbesondere die Wasserabführung bei Regen unterstützen.

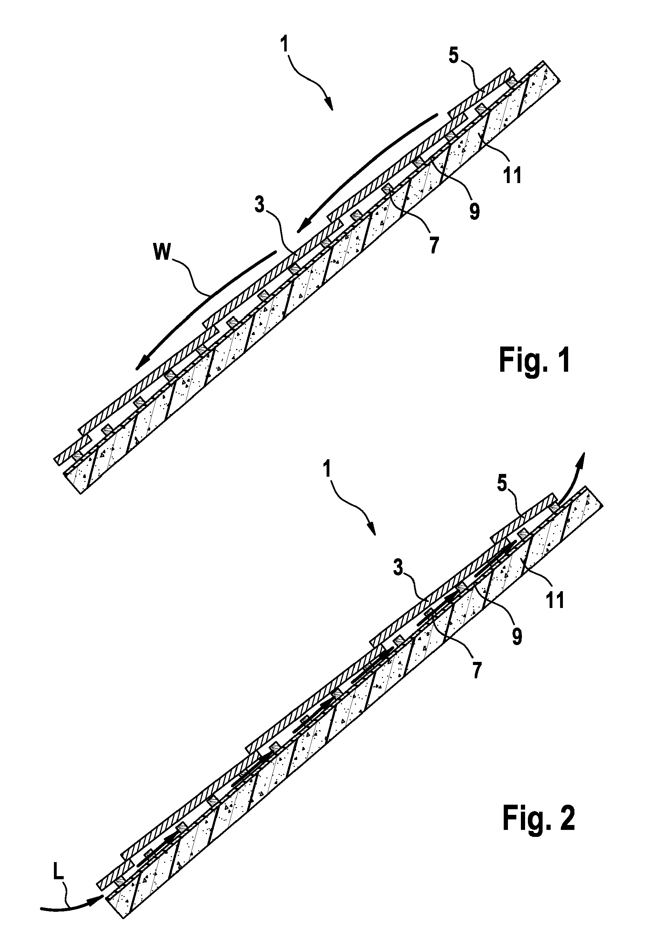

Fig. 1 und 2 zeigen zwei Varianten eines Solarzellen-Dachsystems in Indachmontage. Beide Systeme sind konstruktiv gleich aufgebaut und daher in beiden Figuren mit der Ziffer 1 bezeichnet. Sie bestehen jeweils aus mehreren Solarmodulen **3,** die dachziegelartig überlappend in eine Dacheindeckung mit herkömmlichen Eindeckungselementen **5** eingefügt sind. Die Solarzellen **3** und Eindeckungselemente **5** liegen in der gezeigten Weise auf einer Lattung **7,** welche wiederum über einer Dichthaut **9** und einer Dämmschicht **11** auf einer (nicht dargestellten) Tragkonstruktion des Dachs angeordnet sind. Die Ausführung nach Fig. 2 unterscheidet sich von derjenigen nach Fig. 1 dadurch, dass eine Hinterlüftung realisiert wurde. Hierbei tritt die Luft am untersten Modul ein und strömt bis zum obersten Modul hinter den Modulen entlang. Dies ist in Fig. 2 durch Pfeile **L** am unteren Ende des gezeigten Dachabschnitts und unterhalb der Solarzellen **3** symbolisiert; während in Fig. 1 das über die Solarmodule **3** abfließende Wasser mit den Pfeilen **W** symbolisiert ist. Entweichen muss die erwärmte Luft dann im oberen Dachbereich.

Mitunter sind diese Systeme auch gänzlich ohne Hinterlüftung ausgelegt, da diese besonders aufwendig ist, wenn (wie in Fig. 1 dargestellt) das Solarzellen-Dachsystem als wasserführende Schicht ausgeführt ist. Die starke Erwärmung der Solarmodule hat einen negativen Effekt auf den Wirkungsgrad, da die Leistung der PV Module mit steigender Temperatur abnimmt.

### Offenbarung der Erfindung

Mit der Erfindung wird ein Solarzellen-Dachsystem mit den Merkmalen des Anspruchs 1 bereitgestellt. Zweckmäßige Fortbildungen des Erfindungsgedankens sind Gegenstand der abhängigen Ansprüche. Der Begriff Dachsystem" soll hier auch Fassadensysteme umfassen, die Aufgaben einer Gebäudehülle außerhalb eines Daches übernehmen, insbesondere den Wetterschutz.

In einer Ausführung der Erfindung sind die erfindungsgemäßen Luftführungsmittel in der Unterkante und der gegenüberliegenden Oberkante des Solarmoduls vorgesehen. Des Weiteren sind insbesondere die Luftführungsmittel jeweils in oder nahe einem Rahmenteil des Solarmoduls ausgebildet.

In einer weiteren Ausführung umfassen die Luftführungsmittel einen Ausschnitt im Rahmenteil, insbesondere jeweils einen Ausschnitt in einem Unterkanten-Rahmenteil und einem Oberkanten-Rahmenteil, des Solarmoduls. In einer noch weiteren Ausführung sind den Luftführungsmitteln jeweils Wasserabweismittel zur Abweisung von aufstrebendem Wasser zugeordnet. Speziell umfassen wobei die Wasserabweismittel keilförmige Ausformungen oder keilförmig ausgeformte Zusatzteile an einem Oberkanten-Rahmenteil des Solarmoduls.

In einer weiteren Ausführung der Erfindung weist das erfindungsgemäße Dachsystem Modul-Steckverbinderprofile auf, welche zugleich zur korrekten Positionierung der übereinander zu montierenden Solarmodule dienen. Des Weiteren ist vorgesehen, dass die Modul-Steckverbinderprofile zugleich die keilförmig ausgeformten Zusatzteile bilden. Schließlich umfasst das vorgeschlagene System vorteilhafterweise eine Abschlusshutze zur Montage über einem Solarmodul, welche einen V- oder U-förmigen Luftauslasskanal zum Auslassen von Luft von hinter der Rückseite des entsprechenden Solarmoduls, bei gleichzeitiger Verhinderung des Eindringens von Niederschlagswasser, und Steckverbindermittel zum Aufstecken auf eine Kante des Solarmoduls aufweist. Des Weiteren umfasst ein zweckmäßiges Solarzellen-Dachsystem ein Unterkanten-Steckverbinderprofil mit als Luftführungsmittel dienenden Ausnehmungen, zur Montage unter einem untersten Solarmodul des Solarzellen-Dachsystems.

### Zeichnungen

Weitere Vorteile und vorteilhafte Ausgestaltungen der erfindungsgemäßen Gegenstände werden durch die Zeichnungen veranschaulicht und in der nachfolgenden Beschreibung erläutert. Dabei ist zu beachten, dass die Zeichnungen nur beschreibenden Charakter haben und nicht dazu gedacht sind, die Erfindung in irgendeiner Form einzuschränken. Es zeigen:
- Fig. 1 und Fig. 2: schematische Querschnittsdarstellungen eines Dachaufbaus mit einem bekannten Solarzellen-Dachsystem,
- Fig. 3: eine schematische Querschnittsdarstellung eines Dachaufbaus mit einem erfindungsgemäßen Solarzellen-Dachsystem,
- Fig. 4: eine perspektivische Darstellung (Detailansicht) einer Ausführungsform des erfindungsgemäßen Solarzellen-Dachsystems,
- Fig. 5: eine perspektivische Darstellung (Detailansicht) eines Modul-Steckverbinderprofils einer Ausführungsform des erfindungsgemäßen Solarzellen-Dachsystems,
- Fig. 6: eine schematische Querschnittsdarstellung einer Abschlusshutze einer Ausführungsform des erfindungsgemäßen Solarzellen-Dachsystems und
- Fig. 7: eine perspektivische Darstellung (Detailansicht) eines speziellen Modul-Steckverbinderprofils einer Ausführungsform des erfindungsgemäßen Solarzellen-Dachsystems.

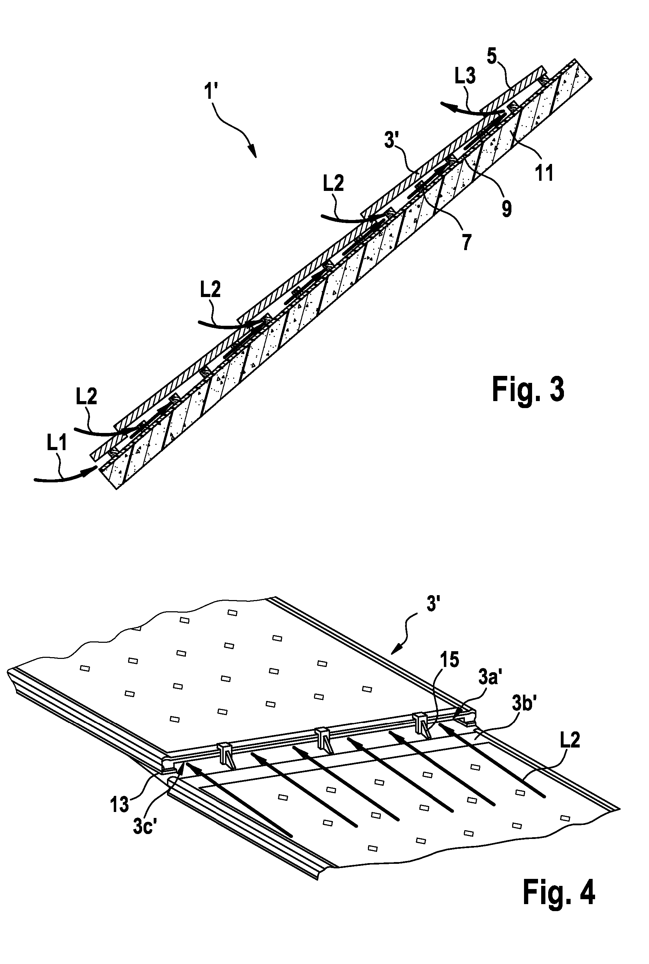

Fig. 3 zeigt, in Anlehnung an die Darstellung in Fig. 1 und 2, schematisch den Aufbau eines erfindungsgemäßen Solarzellen-Dachsystems **1',** wobei gleiche oder funktionsgleiche Teile mit den gleichen Ziffern wie in Fig. 1 und Fig. 2 bezeichnend sind und hier nicht nochmals erläutert werden. Das Dachsystem **1'** unterscheidet sich con dem Dachsystem 1 nach Fig. 2 dadurch, dass nicht nur unterhalb des Systems, also unterhalb des untersten Solarzellenmoduls **3',** ein Luftstrom **L1** hinter die Solarzellenmodule eintritt, sondern jeweils auch an den Unterkanten der einzelnen Module bzw. zwischen deren Oberkante und der Unterkante des darüber angeordneten Moduls, zusätzliche Luftströme **L2** eintreten. Dies wird durch eine gegenüber der Anordnung nach Fig. 2 modifizierte konstruktive Ausbildung und Montage der Solarzellenmodule **3'** mit speziellen (in Fig. 3 nicht zu erkennenden) Luftführungsmitteln erreicht. Darüber hinaus ist bei dem vorgeschlagenen System ein Luftaustritt **L3** direkt an der Oberkante des obersten Solarzellenmoduls **3',** also benachbart zum sich daran anschließenden Dacheindeckungselement **5,** vorgesehen. Auch die hierzu eingesetzten Mittel werden in anderen Figuren gezeigt und weiter unten beschrieben.

Fig. 4 zeigt die einander benachbarten Kantenbereiche zweier Solarmodule **3'** eines Solarzellen-Dachsystems **1'** der in Fig. 3 gezeigten Art genauer. Ein Unterkanten-Rahmenteil **3a'** weist ebenso einen Ausschnitt **3c'** auf wie ein benachbartes Oberkanten-Rahmenteil **3b'** des unterhalb benachbarten Solarzellenmoduls, so dass ein Luftstrom **L2** zwischen diese gelangen kann. Verbunden sind die benachbarten Solarzellenmodule über ein Modul-Steckverbinderprofil **13,** auf das mehrere Steckverbinder **15** zum elektrischen Anschluss und zur mechanischen Fixierung des jeweiligen Moduls aufgesetzt sind.

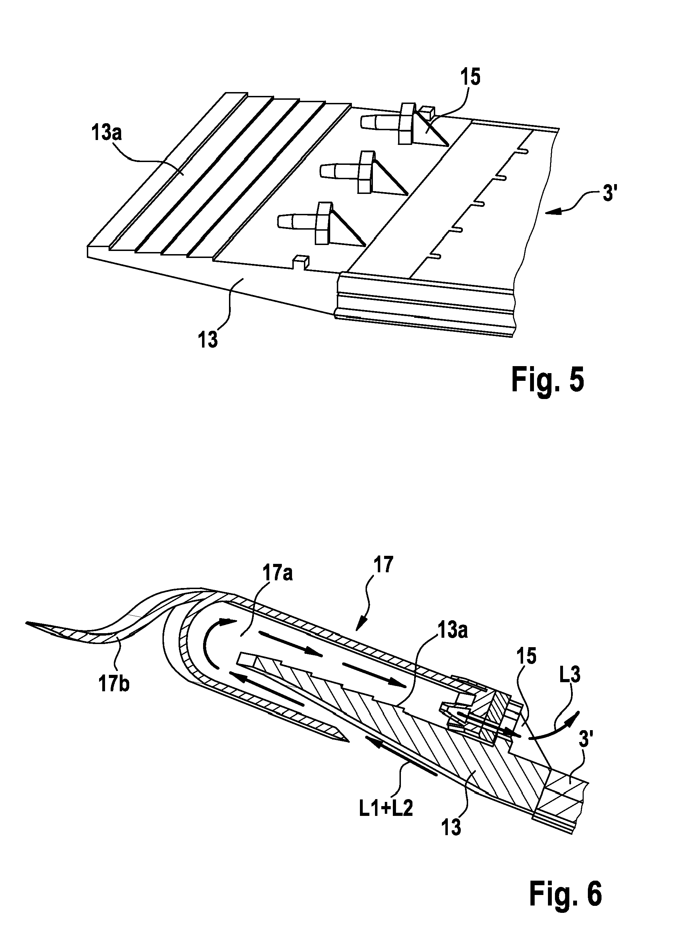

Fig. 5 zeigt in einer perspektivischen Detailansicht ein solches Modul-Steckverbinderprofil **13** und die darauf angeordneten Steckverbinder **15** genauer. Es ist zu erkennen, dass der Querschnitt des Profils **13** flach trapezförmig, seine Gestalt also insgesamt als keilförmig anzusehen ist. Auf seiner Oberseite ist eine Mehrzahl von kleinen keilförmigen Ausformungen 13a vorgesehen, die im Gebrauchszustand ein Aufsteigen von Niederschlagswasser zwischen dem Profil **13** und dem darauf montierten Solarzellenmodul **3'** hinter dessen Rückseite weitgehend unterbinden sollen.

Fig. 6 zeigt das Modul-Steckverbinderprofil **13** mit einem der Steckverbinder **15** nochmals im Querschnitt, und zwar in seinem Einsatz als Steckverbindermittel zum Aufsetzen einer Abschlusshutze **17** auf die Oberkante des Solarzellen-Dachsystems **1'.** Diese Abschlusshutze **17** dient zur Führung des von der Rückseite des Solarzellen-Dachsystems ausgehenden Luftstroms **L3** bei gleichzeitiger Verhinderung des Eindringens von Niederschlagswasser. Sie umfasst dazu einen im Querschnitt U-förmigen Luftkanal **17a,** der unter Einbeziehung des Modul-Steckverbinderprofils **13** gebildet wird. Ein angeformter Fortsatz **17b** sichert eine wasserdichte Einpassung unter an sich oben an das Solarzellen-Dachsystem anschließendes (nicht gezeigtes) Dacheindeckungselement.

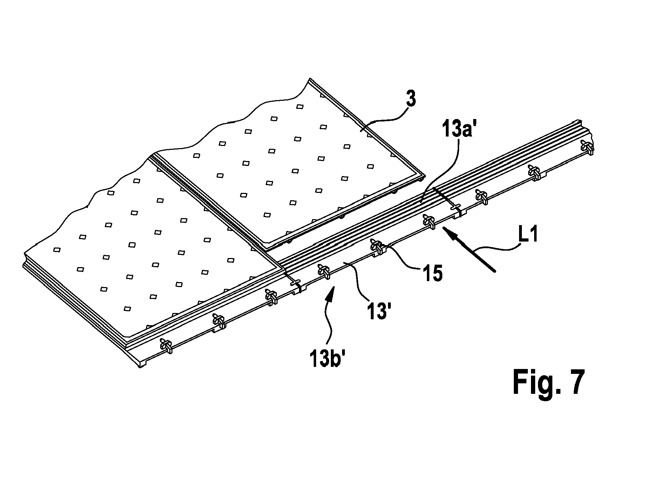

Fig. 7 zeigt in einer perspektivischen Detailansicht als weiteres Teil der hier erläuterten Ausführungsform der Erfindung spezielle Steckverbinderprofile **13',** welche als unterstes Profil eines Solarzellen-Dachsystems einzusetzen sind und hierzu an der Unterkante Ausnehmungen **13a'** haben, die das Eindringen eines Luftstroms **L1** hinter die Rückseite des Dachsystems von dessen Unterkante aus erlauben.

Im Rahmen fachmännischen Handelns ergeben sich weitere Ausgestaltungen und Ausführungsformen des hier nur beispielhaft beschriebenen Verfahrens und der Vorrichtung.

## Patentansprüche

1. Solarzellen-Dachsystem (1') mit einer Mehrzahl von Solarmodulen (3'), von denen zumindest einige zur Realisierung eines Regenschutzes zusammenhängend übereinander zu montieren sind, wobei in oder an mindestens jeweils einer Kante der übereinander zu montierenden Solarmodule, die in Gebrauchslage eine Unterkante ist, Luftführungsmittel (3c;13b) zur Zuführung von Umgebungsluft hinter die Rückseite des Solarmoduls vorgesehen sind.

2. Solarzellen-Dachsystem nach Anspruch 1,
wobei Luftführungsmittel (3c') in der Unterkante und der gegenüberliegenden Oberkante des Solarmoduls (3') vorgesehen sind.

3. Solarzellen-Dachsystem nach Anspruch 1 oder 2,
wobei die Luftführungsmittel (3c') jeweils in einem Rahmenteil (3a';3b') des Solarmoduls (3') ausgebildet sind.

4. Solarzellen-Dachsystem nach Anspruch 3,
wobei die Luftführungsmittel (3a';3b') einen Ausschnitt im Rahmenteil, insbesondere jeweils einen Ausschnitt in einem Unterkanten-Rahmenteil (3a') und einem Oberkanten-Rahmenteil (3b'), des Solarmoduls (3') umfassen.

5. Solarzellen-Dachsystem nach einem der vorangehenden Ansprüche,
wobei den Luftführungsmitteln jeweils Wasserabweismittel (13a) zur Abweisung von aufstrebendem Wasser zugeordnet sind.

6. Solarzellen-Dachsystem nach Anspruch 5,
wobei die Wasserabweismittel (13a) keilförmige Ausformungen oder keilförmig ausgeformte Zusatzteile an einem Oberkanten-Rahmenteil des Solarmoduls (3') umfassen.

7. Solarzellen-Dachsystem nach einem der vorangehenden Ansprüche, welches Modul-Steckverbinderprofile (13) aufweist, welches zugleich zur korrekten Positionierung der übereinander zu montierenden Solarmodule (3') ausgebildet ist.

8. Solarzellen-Dachsystem nach Anspruch 6 und 7,
wobei die Modul-Steckverbinderprofile zugleich die keilförmig ausgeformten Zusatzteile bilden.

9. Solarzellen-Dachsystem nach einem der vorangehenden Ansprüche, umfassend eine Abschlusshutze (17) zur Montage über einem Solarmodul, welche einen V- oder U-förmigen Luftauslasskanal (17a) zum Auslassen von Luft von hinter der Rückseite des entsprechenden Solarmoduls (3'), bei gleichzeitiger Verhinderung des Eindringens von Niederschlagswasser, und Steckverbindermittel (13) zum Aufstecken auf eine Kante des Solarmoduls aufweist.

10. Solarzellen-Dachsystem nach einem der Ansprüche 7 bis 9, umfassend ein Unterkanten-Steckverbinderprofil (13') mit als Luftführungsmittel (13b') dienenden Ausnehmungen, zur Montage unter einem untersten Solarmodul (3') des Solarzellen-Dachsystems.
